# EUROPÄISCHE PATENTSCHRIFT

(11) **EP 2 630 011 B1**
(45) Veröffentlichungstag und Bekanntmachung des Hinweises auf die Patenterteilung: **01.11.2017**
(21) Anmeldenummer: 11760724.2
(22) Anmeldetag: 29.08.2011
(51) Int. Cl.: E05F 15/00

(54) **KAPAZITIVE SENSORANORDNUNG ZUR SCHALTUNG EINER TÜRÖFFNUNG AN EINEM KRAFTFAHRZEUG**
CAPACITIVE SENSOR ASSEMBLY FOR DECIDING ON OPENING A DOOR OF A VEHICLE
ENSEMBLE DE DÉTECTEURS CAPACITIVES POUR DÉCIDER SUR L'OUVERTURE D'UNE PORTE D'UN VÉHICULE

(30) Priorität: 22.10.2010 DE 102010060122
(43) Veröffentlichungstag der Anmeldung: 28.08.2013
(73) Patentinhaber: Huf Hülsbeck & Fürst GmbH & Co. KG, 42551 Velbert (DE)
(72) Erfinder: LANGE, Stefan, 42579 Heiligenhaus (DE)
(74) Vertreter: Zenz Patentanwälte Partnerschaft mbB
(86) Internationale Anmeldenummer: PCT/EP2011/064835
(87) Internationale Veröffentlichungsnummer: WO 2012/052210

(56) Entgegenhaltungen:
- EP-A1- 2 159 362
- EP-A2- 0 770 749
- DE-A1-102008 063 366
- DE-B3-102005 032 402

## Beschreibung

Die Erfindung betrifft eine kapazitive Sensoranordnung mit einer Sensorelektrode, mit deren Hilfe das Eindringen eines Objekts in einen Raum vor der Sensorelektrode erfasst werden soll, einer mit der Sensorelektrode gekoppelten Steuer- und Auswerteschaltung, die eine Änderung der Kapazität der Sensorelektrode gegenüber einem Referenzpotential erfasst. Dies kann geschehen indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass ihr Potential dem Potential der Sensorelektrode nachgeführt wird, ist beispielsweise aus den Veröffentlichungen EP 0 518 836 A1, US 6,825,752 B2, DE 101 31 243 C1 und DE 10 2006 044 778 A1 bekannt. Das aus diesen Druckschriften bekannte Vorsehen einer Schirmelektrode zwischen der Sensorelektrode und der auf MassePotential liegenden Hintergrundelektrode hat den Vorteil, dass die Empfindlichkeit des so gebildeten kapazitiven Sensors gegenüber Veränderungen im Raum vor der Sensorelektrode, beispielsweise durch Einbringen von Objekten, erhöht wird. Dies liegt vor allem daran, dass sich das von der Sensorelektrode ausbreitende Feld stärker in den Raum vor der Sensorelektrode (Detektionsbereich) erstreckt, weil nicht mehr - wie bei fehlender Schirmelektrode - ein großer Teil des Feldes zu der auf Masse-Potential liegenden Hintergrundelektrode kurzgeschlossen wird. Aufgrund des Umstands, dass die Schirmelektrode derart mit der Sensorelektrode gekoppelt ist, dass sie deren Potential nachgeführt wird, entsteht das starke elektrische Feld zwischen der Schirmelektrode und der Hintergrundelektrode; vor allem aber bildet sich praktisch kein Feld aus zwischen der Sensorelektrode und der potentialmäßig nachgeführten Schirmelektrode.

Die bekannte Anordnung von Sensorelektrode, Schirmelektrode und Hintergrundelektrode ist üblicherweise von einem elektrischen Isolator, beispielsweise einem Kunststoff, umhüllt, so dass sich eine Isolatorschicht, beispielsweise Kunststoffschicht, auf der Sensorelektrode und somit zwischen der Sensorelektrode und dem zu überwachenden Raum vor der Sensorelektrode, das heißt dem Detektionsbereich, befindet.

Derartige Sensorelektroden können verwendet werden, um eine Tür eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten. Eine Sensoranordnung mit zwei Sensorelektrodenanordnungen ist aus die DE 10 2008 063 366 A gemäß Oberbegriff des Anspruchs 1 bekannt. Ein Problem mit den bekannten Einrichtungen besteht darin, dass es zu Fehlerkennungen kommen kann, welche unerwünschte Schalt- bzw. Betätigungsvorgänge auslösen, wenn Bewegungen von Gegenständen durch die Sensorik fehlinterpretiert werden.

Aufgabe der Erfindung ist es daher, eine verlässliche Sensorik bereitzustellen, welche die Fehlerfassungen von Betätigungsanforderungen reduziert.

Erfindungsgemäß wird diese Aufgabe durch eine kapazitive Sensoranordnung mit den Merkmalen des Anspruchs 1 gelöst.

Die erfindungsgemäße kapazitive Sensoranordnung umfasst sich entlang einer ersten Koordinatenlinie erstreckende erste und zweite Sensorelektroden, mit deren Hilfe das Eindringen eines Objekts in einen Raum vor den Sensorelektroden erfasst werden soll. Die Koordinatenlinie ist beispielsweise eine gerade Koordinatenlinie eines kartesischen Koordinatensystems; sie kann aber auch im Raum gekrümmt sein. Eine Sensorelektrodenanordnung ist zu der anderen Sensorelektrode versetzt angeordnet, z.B. in einem tiefer gelegenen oder höher gelegenen Bereich des Stossfängers.

Die kapazitive Sensoranordnung weist ferner eine mit den Sensorelektroden gekoppelte Steuer- und Auswerteschaltung auf, die eine Änderung der Kapazität der Sensorelektroden gegenüber einem Referenzpotential erfasst. Diese Erfassung kann erfolgen, indem sie die Sensorelektroden mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotential, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein.

Gemäß der Erfindung ist wenigstens eine der Sensoranordnungen mit größerer Längserstreckung ausgebildet als die wenigstens eine weitere Sensorelektrodenanordnung. Dabei überragt die längere Sensoranordnung die kürzere zu beiden Seiten der Längserstreckung der kürzeren Sensorelektrodenanordnung.

Die Sensorelektrodenanordnungen werden z.B. in einem Heckstoßfänger angeordnet, um den Bereich hinter dem Stoßfänger und unter dem Stoßfänger zu überwachen. Die Signalmuster der ersten Sensorelektrode und der weiteren Sensorelektrodenanordnung werden wiederholt abgefragt (z.B. in Reaktion auf die Detektion eines ID-Gebers von einem Keyless-Entry-System).

Eine vorgegebene Geste eines Benutzers, z.B. ein angetäuschter Kick unter den Stossfänger, soll zu einem Öffnungs- oder Schließvorgang führen. Dafür werden die Signalfolgen der Sensorelektroden erfasst und mit Signalfolgen verglichen, welche eine gezielte Betätigung der Einrichtung anzeigen.

Die Ausbildung der Sensorelektroden mit signifikant unterschiedlicher Längserstreckung ermöglicht, dass insbesondere in den fehlerkritischen seitlichen Bereichen eine erhöhte Erkennungsgenauigkeit gewährleistet wird.

Die erfindungsgemäße Anordnung erstreckt den Erfassungsbereich einer Elektrodenanordnung in Richtung der Längserstreckung über den Erfassungsbereich der anderen Elektrode hinaus. Dadurch wird in diesem Bereich, in dem die Empfindlichkeit der kürzeren Elektrode schwindet, die Sensitivität der längeren Elektrode jedoch noch gleich bleibt, ein räumlich inhomogenes Erfassungsprofil der Elektroden gebildet, welches auswertbar ist.

Der Erfassungsbereich der kürzeren Elektrodenanordnung ist entsprechend der geringeren körperlichen Ausdehnung stärker auf den gemeinsam von beiden Elektrodenanordnungen überspannten Längsbereich konzentriert. In den seitlichen Bereichen ist vornehmlich oder sogar ausschließlich die längere Sensorelektrode sensitiv. Da die Lage der Elektroden am Fahrzeug bekannt ist, können die Signale der Elektroden auf diese Weise besser differenziert werden. Wird z.B. eine Signaländerung zunächst oder nur auf der längeren Elektrode detektiert, deutet dies auf eine ungezielte Auslösung hin. Der gewünschte Erfassungsbereich liegt nämlich im Bereich der gemeinschaftlich überspannten Längserstreckung beider Elektroden. Eine gleichmäßige Verkürzung beider Elektroden ist diesbezüglich nicht hilfreich, da sie zwar den Erfassungsbereich verkleinert, eine Differenzierung in den Randbereichen aber nicht ermöglicht.

Die erfindungsgemäße Einrichtung ermöglicht verschiedene Arten der Auswertung, einerseits über die Signalstärke von beiden Elektroden und andererseits über die Signalfolge. Insbesondere kann überwacht werden, ob die längere Elektrode als erste auf eine Zustandsänderung anspricht, was auf ein ungezieltes Randereignis hinweist. Über die räumliche Anordnung kann außerdem eine weitere Differenzierung vorgenommen werden, wie unten beschrieben wird. Der Überstand der Elektroden auf beiden Seiten kann symmetrisch bemessen sein, dies ist jedoch nicht zwingend erforderlich. Erfindungsgemäß beträgt der Längenunterschied der Sensorelektrodenanordnungen 5%-30%. Ein derartiger, Längenunterschied gewährleistet einerseits, dass ein deutlicher Überstand vorhanden ist, der auch zu deutlichen Signalunterschieden führt. Andererseits ist auch ein prozentual überwiegender Anteil eines gemeinsamen Erstreckungsbereiches vorhanden, welcher in diesem Bereich eine Detektion, z.B. von Bewegungsgesten erlaubt.

Es ist vorteilhaft, wenn die Sensorelektrodenanordnung mit geringerer Längsabmessung in einer Richtung quer zu ihrer Längserstreckung in geringerem Abstand zu einem durch die Sensorelektrodenanordnungen überwachten Erfassungsbereich angeordnet ist als die Sensorelektrodenanordnung mit größerer Längsabmessung.

Die Anordnung der kürzeren Elektrode näher am Detektionsbereich gewährleistet, dass eine verlässliche zeitliche Abfrage dahingehend erfolgen kann, ob diese Elektrode zuerst eine Annäherung bzw. Zustandsänderung detektiert. Ist dies der Fall, kommt die Annäherung aus einem Zielbereich für gültige Annäherungen. Erfasst hingegen zunächst die längere Elektrode, mit weiterer seitlicher Erstreckung eine Annäherung, obwohl sie mit größerem Abstand (gemessen quer zur Längserstreckung) zum gewünschten Erfassungsbereich angeordnet ist, so deutet dies verlässlich auf eine ungezielte und ungültige Annäherung zur Auslösung der Funktion am Kraftfahrzeug hin.

In einer Weiterbildung der Erfindung ist von den kapazitiven Sensoranordnungen mindestens eine Sensorelektrodenanordnung als segmentierte Sensorelektrodenanordnung ausgebildet. Diese Sensorelektrodenanordnung ist mit derselben oder einer entsprechenden separaten Steuer- und Auswerteschaltung zur Aufladung und Detektion verbunden. Die segmentierte Sensorelektrodenanordnung weist entlang ihrer Erstreckung Bereiche mit unterschiedlicher kapazitiver Sensitivität auf oder ist aus alternierenden Abschnitten mehrerer Elektroden gebildet. Dies bedeutet, dass die segmentierte Sensorelektrodenanordnung in Längsrichtung eine je nach Lage entlang der Sensorelektrode verschiedene Detektion erlaubt. Ein Körperteil, welches entlang der ersten Sensorelektrode bewegt wird, erzeugt je nach Position entsprechend unterschiedlich detektierbare Signale an der zweiten Sensorelektrodenanordnung während die Signale in der ersten Sensorelektrode gleich bleiben, sofern sich der Abstand des Körperteils gegenüber der Elektrode nicht ändert. Diese Einrichtung erlaubt daher die Detektion einer Bewegung entlang der segmentierten Elektrodenanordnung durch wiederholtes Abfragen dieser segmentierten Elektrodenanordnung. Treten bei wiederholten Abfragen veränderte Signalwerte an der segmentierten Sensorelektrode auf, weist dies auf eine Bewegung entlang der Elektrodenanordnung hin. Dadurch können Bewegungen, welche eine Bedienungsgeste darstellen von anderen Bewegungen sicherer unterschieden werden.

Die segmentierte Elektrodenanordnung kann als durchgehende Elektrode mit segmentierten Isolierungen oder Abschirmungen gebildet sein (z.B. Coax-Kabel mit segmentiert entfernter Schirmung). Alternativ können mehrere Segmente von separat gesteuerten und abgefragten Elektrodenabschnitten in einer Linie oder segmentweise versetzt angeordnet sein. Die Anzahl der Segmente beträgt wenigstens zwei, ist nach oben jedoch unbegrenzt. Sowohl die kürzere als auch die längere der Sensorelektrodenanordnungen kann als segmentierte Elektrodenanordnung ausgebildet sein.

Bei dieser Gestaltung der erfindungsgemäßen Einrichtung wird die erste Sensorelektrode dahingehend abgefragt, ob das zeitliche Signalmuster charakteristisch für eines gezielte Betätigungsannäherung bzw. Bewegungsgeste ist, im oben genannten Beispiel also eine Annäherung des Unterschenkels eines Benutzers detektiert und zu ansteigenden Signalwerten führt. Zeitgleich wird die weitere Sensoranordnung abgefragt, welche aufgrund ihrer segmentierten Ausbildung neben einer Annäherung auch eine Bewegung entlang der Längsachse der Anordnung erfasst. Handelt es sich beispielsweise um Elektrodensegmente mit einigen cm Länge, so deutet ein rascher Wechsel der Signalstärken (entweder aufgrund segmentierten Schirmung oder aufgrund Abfrage segmentierter Elektrodenabschnitte) auf eine Bewegung entlang der Längsachse hin. Dadurch kann eine Geste ausgefiltert werden, welche z.B. durch ein spielendes Kind bei Tritt gegen einen Ball hinter dem Fahrzeug ausgeführt wird oder durch ein Tier hervorgerufen würde.

Wesentlich ist, dass die segmentierte Elektrodenanordnung erlaubt, durch wiederholte Signalabfrage eine Lageveränderung des detektierten Körpers entlang der Erstreckung der Anordnung zu erkennen. Ist die segmentierte Elektrodenanordnung aus drei verschiedenen Elektroden mit alternierenden Segmenten (im Schema -1-2-3-1-2-3- etc.) gebildet, ist sogar eine Richtungserkennung der Bewegung möglich.

Es ist außerdem möglich, mehrere segmentierte Sensoranordnungen vorzusehen oder die erste Sensorelektrode zusätzlich ebenfalls als segmentiere Sensoranordnung auszubilden.

In einer bevorzugten Gestaltung besteht die segmentierte Sensoranordnung aus einem länglichen durchgehenden Leiter, der abschnittsweise wechselnde Bereiche mit unterschiedlicher Abschirmung aufweist.

Derartige Sensorelektroden sind besonders einfach herzustellen, da von handelsüblichen Kabeln lediglich abschnittsweise die Isolation oder Abschirmung (z.B. Geflecht bei Koaxialkabeln) zu entfernen ist. Außerdem kann auch ein Draht verwendet werden, der in eine Halterung mit wechselnder Abschirmung in Richtung der Längserstreckung versehen ist. Der Draht erhält dann seine segmentierte Eigenschaft als Sensoranordnung durch Einbringung in die Halterung mit segmentweise unterschiedlicher Schirmwirkung.

In einer weiteren Gestaltung besteht die segmentierte Sensoranordnung aus zwei Sensorelektroden, welche segmentweise in unterschiedlichem Abstand vom Detektionsbereich verlaufen oder mit gegensätzlicher Abschirmung versehen sind. So eine Anordnung kann bspw. durch phasenversetztes umwickeln eines Stabes durch zwei separate Sensorelektroden realisiert werden. Die Elektroden verlaufen wechselnd in unterschiedlichem Abstand und mit unterschiedlicher Schirmung (wechseln vor dem Stab liegend und hinter dem Stab liegend) in Längsrichtung.

In einer bevorzugten Ausführungsform ist die segmentierte Sensoranordnung aus drei getrennt abgefragten Sensorelektroden mit alternierenden Abschnitten gebildet.

Eine solche Anordnung erlaubt neben der Erfassung einer Annäherung außerdem die Erfassung der Bewegungsrichtung vor der Sensorelektrodenanordnung. Dazu wird die Abfolge der Sensorsignale erfasst und die Laufrichtung eines Signalmaximums ermittelt.

Vorteilhafte und/oder bevorzugte Ausführungsformen sind in den Unteransprüchen gekennzeichnet.

Die Erfindung wird nun anhand der beiliegenden Figuren näher erläutert.
Figur 1a zeigt die Anordnung einer ersten Ausführungsform der erfindungsgemäßen Sensoranordnung an einem Kraftfahrzeug;
Figur 1b zeigt die Anordnung aus Figur 1 in einer schematischen Aufsicht;

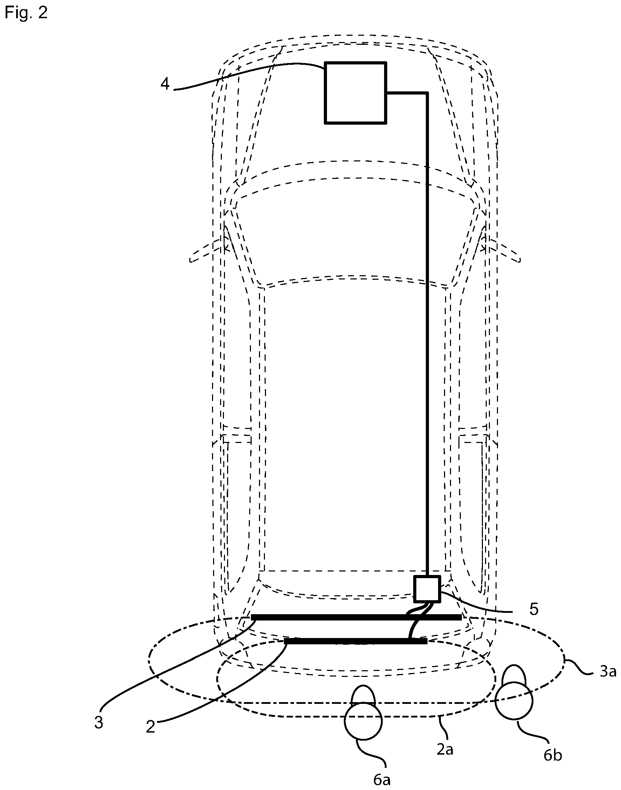

Figur 2 zeigt die Anordnung aus Figur 1 in einer schematischen Aufsicht mit dargestellten Erfassungsbereichen;
Figur 3a zeigt eine erste segmentierte Sensoranordnung zum Einsatz in einer Einrichtung gemäß der Erfindung;
Figur 3b zeigt einen schematischen Signalverlauf bei Detektion einer Längsbewegung mit einer Sensoranordnung aus Figur 3a;
Figur 4a zeigt eine zweite segmentierte Sensoranordnung zum Einsatz in einer Einrichtung gemäß der Erfindung;
Figur 4b zeigt einen schematischen Signalverlauf bei Detektion einer Längsbewegung mit einer Sensoranordnung aus Figur 4a;

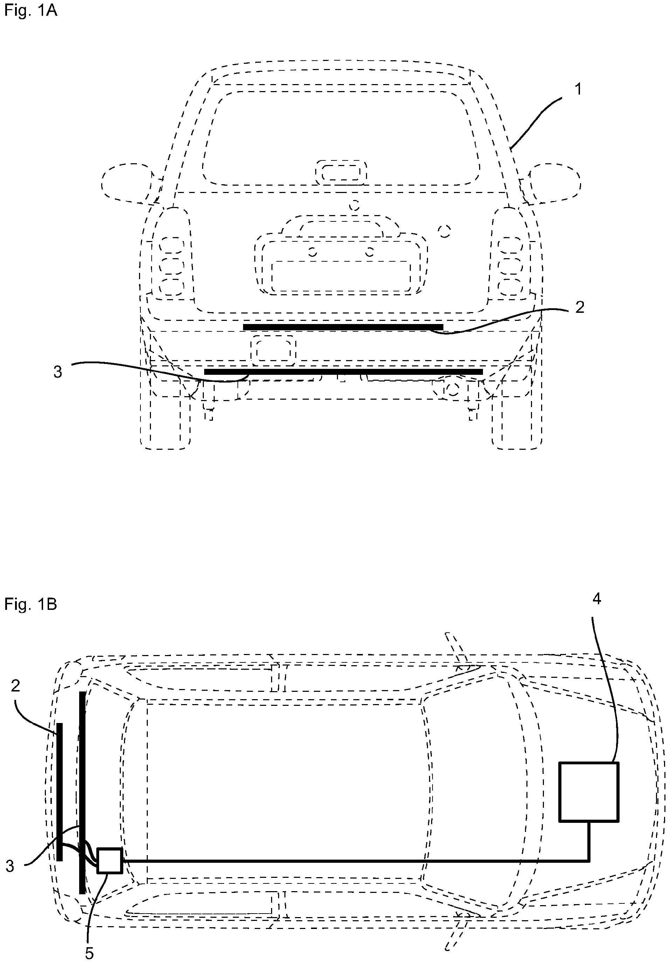

In Figur 1a ist das Heck eines Fahrzeugs 1 gezeigt. Bereich des Heckstossfängers ist eine Sensorelektrodenanordnung 2 angebracht. Unterhalb (also in geringerer Höhe vom Boden) der Sensorelektrodenanordnung 2 ist eine weitere Sensorelektrode 3 angeordnet. Die Sensorelektroden 2 und 3 sind jeweils mit einer Steuer- und Auswerteeinrichtung 5 verbunden. Diese ist wiederum mit einer zentralen Fahrzeugsteuereinheit 4 gekoppelt, welche eine Öffnung der Heckklappe des Fahrzeugs kontrolliert und freigibt. Die Elektroden werden über die Einrichtung 5 aufgeladen und die Kapazitätsänderung der Elektroden bei Annäherung eines Körpers, z.B. eines Bedienerkörperteils kann durch Ladungsauswertung erfasst werden. Dieses Prinzip eines kapazitiven Sensors ist im Bereich der Kraftfahrzeugtechnik bekannt.

Die Sensorelektrodenanordnung 3 verläuft im Wesentlichen parallel zu der Elektrode 2. Die Elektrodenanordnung 3 erstreckt sich jedoch länger als die Elektrodenanordnung 2 und steht seitlich über die Enden der Elektrode 2 hinaus. Die Elektroden 2 und 3 sind hier durchgehend mit im Wesentlichen gleichbleibender Empfindlichkeit ausgebildet. Eine oder beide der Elektroden könnten jedoch auch als segmentierte Elektroden ausgebildet sein, deren Erfassungsempfindlichkeit in Längsrichtung variiert, also in Richtung der Erstreckung des Stoßfängers Bereiche mit wechselnder Erfassungssensitivität aufweist. Eine solche Elektrodenanordnung 2 könnte dann sowohl eine Annäherung erfassen (durch absolute Veränderung des erfassten Signals) als auch eine Bewegung eines Körpers entlang der Segmente. Liegt nämlich der Körper derart vor der Sensorelektrode, dass mehr Segmente bzw. größere Abschnitte mit höherer Erfassungssensitivität hinter Körper liegen als Segmente mit niedrigerer Erfassungssensitivität ist das ermittelte Signal höher als in dem Fall, dass der Körper derart vor der Sensorelektrode angeordnet ist, dass mehr Segmente bzw. größere Abschnitte mit geringerer Erfassungssensitivität hinter Körper liegen als Segmente mit höherer Erfassungssensitivität. Bewegt sich der Körper entlang der Anordnung, ist dies durch eine Signalfluktuation erkennbar, die mit der Auswerteeinrichtung messbar ist. Die Segmente sollten in ihrer Längsabmessung auf die gewünschte Erfassungsgenauigkeit abgestimmt sein, sie können z.B. jeweils eine Länge von 5cm bis 30cm aufweisen.

Da die Segmentierung für die Erfindung jedoch nicht wesentlich ist, wird das Beispiel mit zwei durchgehend homogenen Elektroden beschrieben. Weiter unten wird dann die Gestaltung einer segmentierten Elektrode, welche die Auswertungsmöglichkeiten weiter erhöht, beispielhaft beschrieben.

Bei einem Bedienerwunsch kann ein Bediener bspw. seinen Unterschenkel in einer Schwenkbewegung unter den Stoßfänger bewegen. Diese Bewegung und Annäherung wird sowohl durch die Elektrodenanordnung 2 erfasst, als auch durch die verlängerte Sensorelektrode 3, da die Kapazitätsänderung zeitlich wiederholt abgefragt und die Veränderung ausgewertet wird.

Durch die unterschiedliche Länge der Elektroden dehnen sich außerdem deren Erfassungsbereiche seitlich unterschiedlich weit aus. Wie in Figur 1c gezeigt, weist die Elektrode 3 einen Erfassungsbereich 3a auf, während die Elektrode 2 einen weniger breiten Erfassungsbereich 2a aufweist. Zwei stilisierte Unterschenkel 6a und 6b sind zur Verdeutlichung der unterschiedlichen Erfassungspositionen dargestellt. Der Unterschenkel 6a befindet sich im Erfassungsbereich 2a und, mit geringerer Eindringtiefe, im zurückversetzten Erfassungsbereich 3a. Der Unterschenkel 6b befindet sich hingegen ausschließlich in Erfassungsbereich 3a.

Ein Öffnungskommando wird von der zentralen Steuereinrichtung 4 nur dann generiert, wenn die Elektrodenanordnung 2 bei zeitlicher Abfrage eine Betätigung zuerst registriert. Es soll nämlich nur eine von hinter dem Fahrzeug ausgeführte und auf das Fahrzeug gerichtete Geste als Öffnungskommando interpretiert werden. Demnach wird die Gesamtheit der erfassten Signale ausgewertet, um eine sichere Interpretation einer Öffnungsgeste zu ermöglichen.

Signalverläufe, die auf ein Eindringen eines Bedienerkörperteils zuerst (oder ausschließlich) in den Bereich 3a hinweisen werden bereits in diesem Stadium durch die Erfassungsvorrichtung 5 verworfen. Wird jedoch eine plausible Zeitfolge detektiert (Eindringen zuerst in Bereich 2a und anschließend in 3a), wird die zeitliche Signalfolge weiter analysiert, um zu prüfen, ob tatsächlich eine Betätigungsgeste vorliegt. Dazu können auch die absoluten Signalwerte der Elektroden und deren Verhältnis ausgewertet werden. Die erfindungsgemäß vorliegende unterschiedliche Quererstreckung der Elektroden erhöht die Unterscheidungsgenauigkeit, insbesondere in den kritischen seitlichen Bereichen.

Die Anordnung kann noch um weitere Sensorelektrodenanordnungen ergänzt werden.

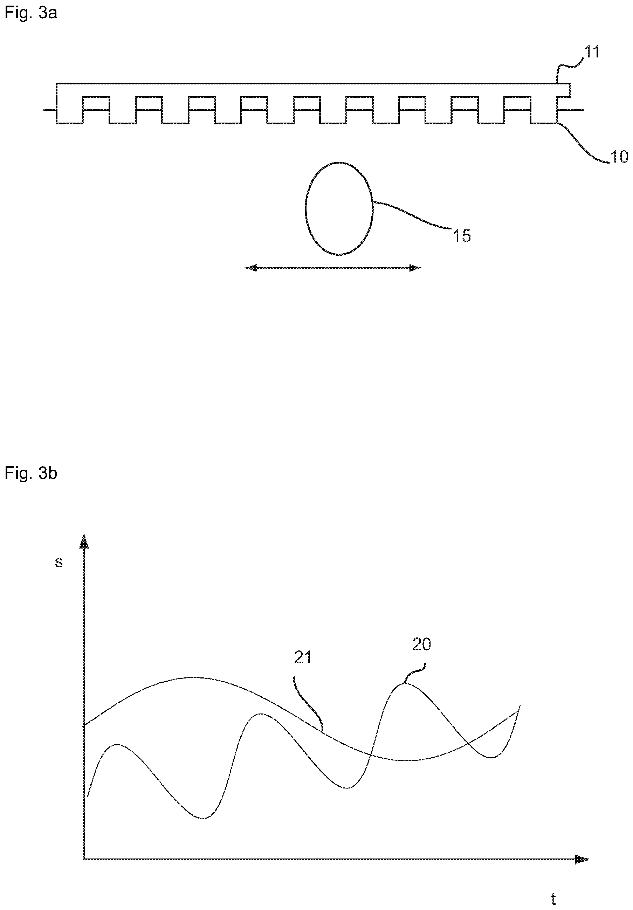

Figur 3a zeigt in schematischer Weise eine mögliche Gestaltung einer segmentierten Sensoranordnung, wie sie bei der Erfindung zum Einsatz kommen kann. Jede der vorstehend genannten Elektroden 2, 3 kann als segmentierte Elektrode ausgebildet werden, um die Auswertungsmöglichkeiten weiter zu verfeinern. Denn zu der erfindungsgemäß verbesserten Randsensitivität tritt außerdem eine Quererkennung der Bewegung hinzu, wie oben erläutert.

In der Abbildung ist beispielhaft eine Sensorelektrode 10 in einer Halterung 11 geführt. Die Halterung 11 umgreift abschnittsweise die Elektrode 10 und bildet so Segmente mit größerer und geringerer Abschirmung.

Ein Objekt 15 kann sich vor der segmentierten Sensoranordnung in Querrichtung bewegen. Dabei befindet es sich je nach Lage vornehmlich vor stärker oder schwächer abgeschirmten Bereichen. In der oben dargestellten Anordnung der Elektroden kann insbesondere Elektrode 2, welche näher am Benutzer angeordnet ist, als segmentierte Elektrode ausgebildet sein.

Figur 3b zeigt einen Idealisierten zeitlichen Signalverlauf für eine Auswertung des Signals bei einer gleichförmigen Bewegung des Objekts vor der Anordnung. Die mittlere Signalstärke (oder auch Offset) wird durch die Nähe des Objekts zur Sensoranordnung bestimmt. Die Schwankung wird jedoch durch die Bewegung des Objekts in Längsrichtung der Anordnung hervorgerufen. Durch geeignete empirische Auswertung und Feststellung von charakteristischen Werten kann ein Signalverlauf 20, welcher durch ein bewegtes Objekt hervorgerufen wird, von einem Verlauf 21, welcher durch eine gezielte Bewegung hervorgerufen wird (Schwenken des Beines auf die Sensoranordnung zu), unterschieden werden.

In Kombination mit der unterschiedlichen Längenausdehnung der Elektroden, wird eine komplexe Auswertung der ausgeführten Bewegungsgesten und eine verlässliche Unterscheidung von zufälligen oder ungezielten Ereignissen möglich.

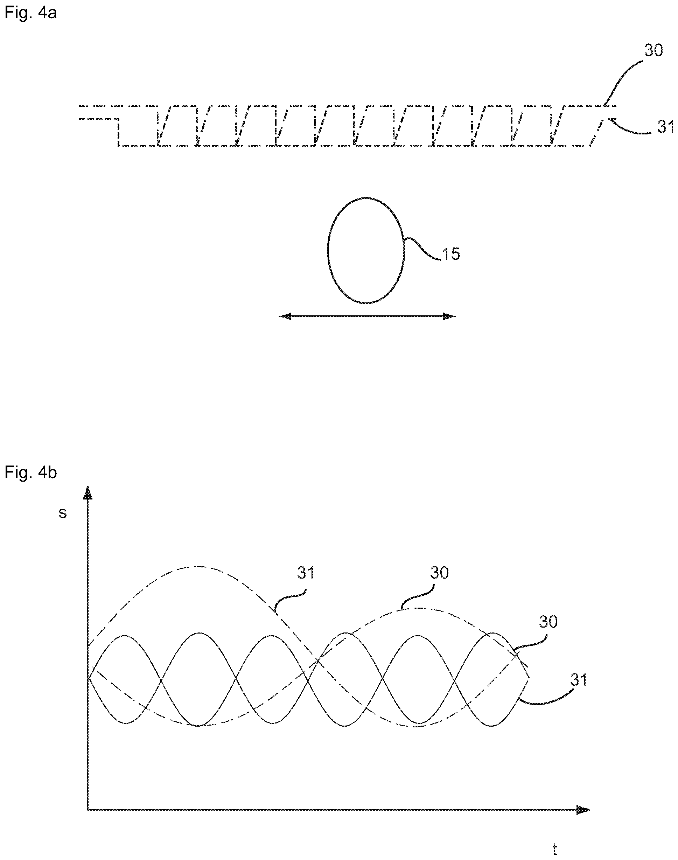

Figur 4a zeigt eine alternative Gestaltung einer segmentierten Sensoranordnung mit zwei separaten kapazitiv abgefragten Elektroden 30, 31. Diese befinden sich abschnittweise in wechselnden Abständen zu dem zu detektierenden Objekt 15.

Figur 4b zeigt wiederum einen Signalverlauf, der hier die zeitlichen Signale beider Elektroden bei einer Querbewegung (durchgezogene Linien) und einer gerichteten Bedienungsgeste (gestrichelt) wiedergibt. Auch hier sind die verschiedenen Signalverläufe klar unterscheidbar und erhöhen die Sicherheit bei der Interpretation der Sensorsignale.

## Patentansprüche

1. Sensoranordnung zur Erfassung von Bewegungsgesten an einem Kraftfahrzeug, mit einer kapazitiven Sensoranordnung (2, 3) und wenigstens einer mit der Sensoranordnung gekoppelten Steuer- und Auswerteeinrichtung (5), die eine Änderung der Kapazität der Sensoranordnung gegenüber einem Referenzpotential erfasst,
wobei wenigstens zwei Sensorelektrodenanordnungen (2, 3) an räumlich versetzten Positionen am Kraftfahrzeug angeordnet sind, wobei die Sensorelektroden (2, 3) als längliche Elektrodenanordnungen ausgebildet und mit gleicher Raumorientierung angeordnet sind,
**dadurch gekennzeichnet,**
**dass** eine (3) der Sensorelektrodenanordnungen mit größerer Längsabmessung ausgebildet ist als die andere (2) Sensorelektrodenanordnung und sich die längere Sensorelektrodenanordnung (3) in Längsrichtung zu beiden Seiten über die kürzere Sensorelektrodenanordnung (2) hinaus erstreckt, wobei der Längenunterschied der Sensorelektrodenanordnungen (2, 3) 5%-30% beträgt und wobei jede Sensorelektrodenanordnung von der Auswerteeinrichtung abfragbar ist, um einen zeitlichen Signalverlauf zu erfassen.

2. Sensoranordnung nach Anspruch 1, wobei die Sensorelektrodenanordnung (2) mit geringerer Längsabmessung in einer Richtung quer zu ihrer Längserstreckung in geringerem Abstand zu einem durch die Sensorelektrodenanordnungen (2, 3) überwachten Erfassungsbereich angeordnet ist als die Sensorelektrodenanordnung (3) mit größerer Längsabmessung.

3. Sensoranordnung nach einem der Ansprüche 1 bis 2, wobei wenigstens eine der Sensorelektrodenanordnungen als abschnittsweise segmentierte kapazitiv erfassende erste Sensorelektrodenanordnung ausgebildet ist, wobei die Segmente in Längsrichtung angeordnet sind und eine abschnittsweise unterschiedliche kapazitive Detektion ermöglichen.

4. Sensoranordnung nach Anspruch 3, wobei die segmentierte erste Sensorelektrodenanordnung durch eine in Längsrichtung abschnittsweise unterschiedliche Abschirmung einer Sensorelektrode gebildet ist.

5. Sensoranordnung nach Anspruch 3, wobei die segmentierte erste Sensorelektrodenanordnung durch alternierende Längsanordnung von wenigstens zwei separat ansteuerbaren Sensorelektroden gebildet ist.

6. Sensoranordnung nach einem der vorstehenden Ansprüche, wobei eine dritte Sensorelektrodenanordnung aus einer homogenen Sensorelektrode gebildet ist und versetzt zu den ersten beiden Sensorelektrodenanordnungen angeordnet ist.

7. Sensoranordnung nach einem der vorstehenden Ansprüche, wobei mehrere Sensorelektrodenanordnungen als segmentierte Sensorelektrodenanordnung ausgebildet sind.

8. Sensoranordnung nach einem der vorstehenden Ansprüche, wobei wenigstens die segmentierte erste Sensorelektrodenanordnung in einem Stoßfänger eines Kraftfahrzeuges angeordnet ist.

## Claims

1. A sensor arrangement for detecting movement gestures on a motor vehicle, with a capacitive sensor arrangement (2, 3) and at least one control and evaluation device (5), which is coupled with the sensor arrangement and which detects a change in the capacitance of the sensor arrangement with respect to a reference potential,
wherein at least two sensor electrode arrangements (2, 3) are arranged at spatially offset positions on the vehicle, wherein the sensor electrodes (2, 3) are constituted as elongated electrode arrangements and are arranged with identical spatial orientation, **characterised in that**
one (3) of the sensor electrode arrangements is constituted with a greater length dimension than the other (2) sensor electrode arrangement and the longer sensor electrode arrangement (3) extends beyond the shorter sensor electrode arrangement (2) at both sides in the longitudinal direction, wherein the length difference of the sensor electrode arrangements (2, 3) amounts to 5%-30% and wherein each sensor electrode arrangement can be interrogated by the evaluation device in order to detect a temporal signal course.

2. The sensor arrangement according to claim 1, wherein the sensor electrode arrangement (2) with a smaller length dimension is arranged in a direction transverse to its longitudinal extension at a smaller distance from a detection region monitored by the sensor electrode arrangements (2, 3) than the sensor electrode arrangement (3) with a greater length dimension.

3. The sensor arrangement according to any one of claims 1 to 2, wherein at least one of the sensor electrode arrangements is constituted as a zonally segmented, capacitively detecting first sensor electrode arrangement, wherein the segments are arranged in the longitudinal direction and enable a zonally different capacitive detection.

4. The sensor arrangement according to claim 3, wherein the segmented first sensor electrode arrangement is formed by a shield of a sensor electrode, which shield differs zonally in the longitudinal direction.

5. The sensor arrangement according to claim 3, wherein the segmented first sensor electrode arrangement is formed by an alternating longitudinal arrangement of at least two separately controllable sensor electrodes.

6. The sensor arrangement according to any one of the preceding claims, wherein a third sensor electrode arrangement is formed from a homogeneous sensor electrode and is arranged offset with respect to the first two sensor electrode arrangements.

7. The sensor arrangement according to any one of the preceding claims, wherein a plurality of sensor electrode arrangements are constituted as a segmented sensor electrode arrangement.

8. The sensor arrangement according to any one of the preceding claims, wherein at least the segmented first sensor electrode arrangement is arranged in a bumper of a motor vehicle.

## Revendications

1. Ensemble de détecteurs pour saisir des gestes de mouvement au niveau d'un véhicule automobile, avec un ensemble capacitif de détecteurs (2,3) et au moins un dispositif de commande et d'exploitation (5) couplé à l'ensemble de capteurs, qui saisit une variation de la capacité de l'ensemble de capteurs par rapport à un potentiel de référence
au moins deux ensembles d'électrodes de capteurs (2,3) étant disposés sur le véhicule automobile à des positions déportées dans l'espace, les électrodes de capteurs (2,3) étant constituées sous la forme d'ensembles d'électrodes oblongs et étant disposées avec la même orientation spatiale,
**caractérisé en ce**
**qu'**un (3) des ensembles d'électrodes de capteurs est constitué avec une dimension longitudinale plus grande que l'autre (2) ensemble d'électrodes de capteurs et l'ensemble d'électrodes de capteurs plus long (3) s'étend dans la direction longitudinale vers les deux côtés au-delà de l'ensemble d'électrodes de capteurs plus court (2), la différence de longueur des ensembles d'électrodes de capteurs (2,3) étant de 5%-30% et chaque ensemble d'électrodes de capteurs pouvant être interrogé par le dispositif d'exploitation pour saisir une allure de signal temporelle.

2. Ensemble de capteurs selon la revendication 1, l'ensemble d'électrodes de capteurs (2) avec une dimension longitudinale inférieure étant disposé dans une direction transversalement à son extension longitudinale par rapport à une zone de saisie surveillée par les ensembles d'électrodes de capteurs (2,3) à une distance plus faible que l'ensemble d'électrodes de capteurs (3) avec une dimension longitudinale plus grande.

3. Ensemble de capteurs selon l'une quelconque des revendications 1 à 2, au moins un des ensembles d'électrodes de capteurs étant constitué sous la forme d'un premier ensemble d'électrodes de capteurs segmenté par section saisissant de façon capacitive, les segments étant disposés en direction longitudinale et permettant une détection capacitive différente par section.

4. Ensemble de capteurs selon la revendication 3, le premier ensemble segmenté d'électrodes de capteurs étant constitué par un blindage d'une électrode de capteur, différent par section dans la direction longitudinale.

5. Ensemble de capteurs selon la revendication 3, le premier ensemble segmenté d'électrodes de capteurs étant formé par un montage longitudinal alterné d'au moins deux électrodes de capteur pouvant être commandées séparément.

6. Ensemble de capteurs selon l'une quelconque des revendications précédentes, un troisième ensemble d'électrodes de capteurs étant formé d'une électrode de capteur homogène et étant disposé décalé par rapport aux deux premiers ensembles d'électrodes de capteurs.

7. Ensemble de capteurs selon l'une quelconque des revendications précédentes, plusieurs ensembles d'électrodes de capteurs étant constitués sous la forme d'un ensemble segmenté d'électrodes de capteurs.

8. Ensemble de capteurs selon l'une quelconque des revendications précédentes, au moins le premier ensemble segmenté d'électrodes de capteurs étant disposé dans un pare-chocs d'un véhicule automobile.
